# EUROPÄISCHE PATENTSCHRIFT

(11) **EP 1 181 712 B1**
(45) Veröffentlichungstag und Bekanntmachung des Hinweises auf die Patenterteilung: **24.01.2007**
(21) Anmeldenummer: 00934909.3
(22) Anmeldetag: 13.04.2000
(51) Int. Cl.: H01L 29/78, H01L 29/739, H01L 29/06, H01L 29/10, H01L 21/336, H01L 21/331

(54) **NIEDEROHMIGES VDMOS-HALBLEITERBAUELEMENT**
LOW-RESISTANCE VDMOS SEMICONDUCTOR COMPONENT
COMPOSANT SEMI-CONDUCTEUR VDMOS A FAIBLE RESISTANCE

(30) Priorität: 12.05.1999 DE 19922187
(43) Veröffentlichungstag der Anmeldung: 27.02.2002
(73) Patentinhaber: Infineon Technologies AG, 81669 München (DE)
(72) Erfinder: TIHANYI, Jenoe, D-85551 Kirchheim (DE); WERNER, Wolfgang, D-81545 München (DE)
(74) Vertreter: Kottmann, Heinz Dieter
(86) Internationale Anmeldenummer: PCT/DE2000/001155
(87) Internationale Veröffentlichungsnummer: WO 2000/070654

(56) Entgegenhaltungen:
- DE-A- 19 534 154
- JP-A- 8 222 735
- DEBOY G ET AL: "NEW GENERATION OF HIGH VOLTAGE MOSFETS BREAKS THE LIMIT LINE OF SILICON" INTERNATIONAL ELECTRON DEVICES MEETING, TECHNICAL DIGEST, SAN FRANCISCO, CA, 6. - 9. Dezember 1998, Seiten 683-685, XP000859463 IEEE, NEW YORK, NY, USA ISBN: 0-7803-4775-7

## Beschreibung

Die vorliegende Erfindung betrifft ein niederohmiges VDMOS-Halbleiterbauelement mit planarer Gatestruktur, bei dem in einem Halbleiterkörper des einen Leitungstyps, der zwei einander im wesentlichen gegenüberliegende Hauptoberflächen aufweist, im Bereich der einen Hauptoberfläche eine hochdotierte erste Zone des einen Leitungstyps vorgesehen ist, die durch eine zweite Zone des anderen Leitungstyps von dem Halbleiterkörper getrennt ist, und bei dem die erste und die zweite Zone von einem bis zum Halbleiterkörper reichenden Graben durchsetzt sind. Bei einem solchen niederohmigen VDMOS-Halbleiterbauelement kann es sich insbesondere um einen VDMOS-Feldeffekttransistor und beispielsweise auch um einen IGBT (Bipolartransistor mit isoliertem Gate) handeln. Außerdem betrifft die vorliegende Erfindung ein Verfahren zum Herstellen eines solchen niederohmigen VDMOS-Halbleiterbauelements.

Ein herkömmlicher niederohmiger Trench- bzw. Graben-MOS-Feldeffekttransistor für Spannungen zwischen etwa 20 bis 100 V ist in Fig. 4 gezeigt (vgl. hierzu auch US 4 941 026). Dieser herkömmliche Trench-MOSFET weist einen Halbleiterkörper 1 mit einer n⁺-dotierten Drainzone 2, einer n-dotierten Halbleiterzone 3, einer p-dotierten Halbleiterzone 4 und einer n⁺-dotierten Sourcezone 5 auf. Durch die Sourcezone 5, die Halbleiterzone 4 und die Halbleiterzone 3 erstreckt sich bis zu der Drainzone 2 ein ringförmiger Graben bzw. Trench 6, dessen Wand mit einer Isolierschicht 7 aus beispielsweise Siliziumdioxid belegt ist und der mit n⁺-leitendem polykristallinem Silizium 8 gefüllt ist.

Auf dem Halbleiterkörper 1, der aus entsprechend dotiertem Silizium besteht, befindet sich eine Metallisierung 9 aus beispielsweise Aluminium für eine geerdete Sourceelektrode S. Die Drainzone 2 ist mit einer Drainelektrode D verbunden, an der eine Drainspannung +U_{D} anliegt. Das polykristalline Silizium 8 im Graben 6 ist schließlich mit einer Gateelektrode G verbunden.

Ein derartiger herkömmlicher Trench-MOS-Feldeffekttransistor ist niederohmig und kann ohne weiteres für Spannungen zwischen etwa 20 bis 100 V eingesetzt werden. Er ist aber in seiner Herstellung - bedingt durch die tiefen Trench-Gates - relativ aufwendig.

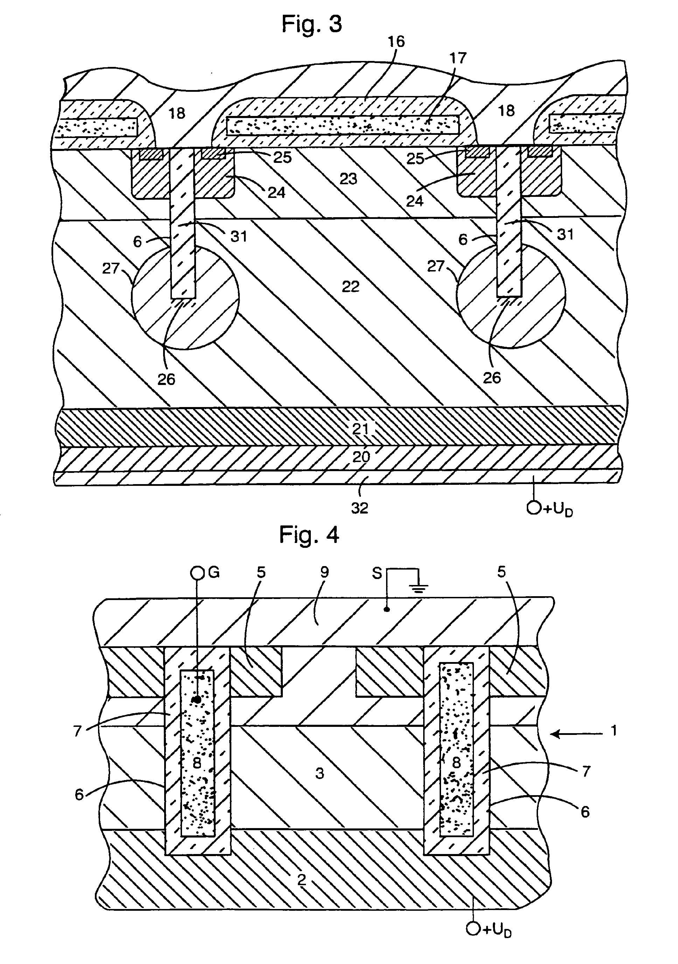

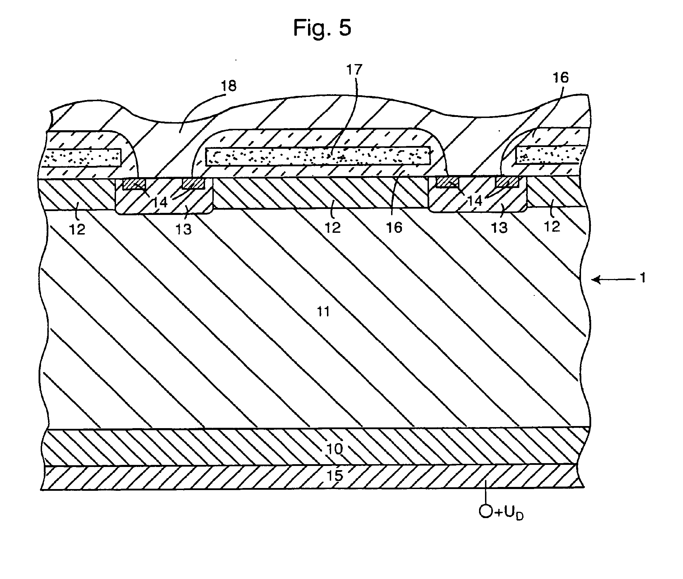

Ein anderer herkömmlicher MOS-Feldeffekttransistor, beispielsweise der sogenannte "HEXFET", ist in Fig. 5 gezeigt. Dieser besteht aus einem Halbleiterkörper 1 mit einer n⁺-leitenden Drainzone 10, einer n⁻-leitenden Halbleiterzone 11, einer n-leitenden Halbleiterzone 12, einer p-leitenden ringförmigen Halbleiterzone 13, und n⁺-leitenden Halbleiterzonen 14. Der Halbleiterkörper 1 besteht mit seinen jeweiligen Zonen 10 bis 14 wie bei dem Beispiel von Fig. 4 aus entsprechend dotiertem Silizium.

Auf der Halbleiterzone 10 ist ein Drainkontakt 15 angebracht, an dem die Drainspannung +U_{D} anliegt. Auf der dem Drainkontakt 15 gegenüberliegenden Seite des Halbleiterkörpers 1 ist in eine Gateoxidschicht 16 aus beispielsweise Siliziumdioxid eine Gateelektrode 17 aus n⁺-dotiertem polykristallinem Silizium eingebettet. Außerdem befindet sich auf dieser Oberflächenseite noch eine Metallisierung 18 aus beispielsweise Aluminium zur Kontaktierung der Sourcezonen 14.

Ein MOSFET mit der in Fig. 5 gezeigten Struktur ist zwar einfacher herstellbar als der MOSFET von Fig. 4. Er ist aber flächenaufwendiger, da bei ihm kein Trench vorgesehen ist.

Es ist daher Aufgabe der vorliegenden Erfindung, ein niederohmiges VDMOS-Halbleiterbauelement zu schaffen, das auf einfache Weise herstellbar ist und wenig Fläche beansprucht; außerdem soll ein Verfahren zum Herstellen eines solchen VDMOS-Halbleiterbauelementes angegeben werden.

Diese Aufgabe wird bei einem niederohmigen VDMOS-Halbleiterbauelement gemäß Anspruch 1 gelöst.

Ein Bauelement gemäß dem Oberbegriff des Anspruchs 1 ist aus JP-A-8 222 735 bekannt. Weitere niederohmige VDMOS-Halbleiterbauelemente sind aus DE-A-19534154 und IEDM 98 Technical Digest, Seiten 683-685 bekannt.

Es ist vorteilhaft, daß das Gebiet des anderen Leitungstyps bis zur zweiten Zone reicht und der Graben mit leitendem Material wenigstens bis zu dem der einen Hauptoberfläche zugewandten Rand der zweiten Zone mit leitendem Material gefüllt ist.

Außerdem ist zweckmäßig, daß im Halbleiterkörper unterhalb des Gebietes des anderen Leitungstyps wenigstens ein an dieses angrenzendes weiteres Gebiet des anderen Leitungstyps vorgesehen ist.

Wenn das Halbleiterbauelement ein IGBT ist, kann der Graben gegebenenfalls auch ganz mit Isoliermaterial gefüllt sein.

Für das Isoliermaterial kann Glas, wie beispielsweise "Flowglas" verwendet werden. Es ist auch vorteilhaft, daß im Halbleiterkörper eine obere Epitaxieschicht höher dotiert ist als darunterliegende Epitaxieschichten.

Ein Verfahren zum Herstellen eines Halbleiterbauelements der oben genannten Art zeichnet sich dadurch aus, daß das Gebiet des anderen Leitungstyps durch Ausdiffusion eines Dotierstoffes des anderen Leitungstyps aus dem Bereich des Bodens des Grabens vorgenommen wird. Wenn der eine Leitungstyp n-leitend ist, wird als Dotierstoff für den anderen Leitungstyp in bevorzugter Weise Bor vorgesehen. In diesem Fall wird also Bor aus dem Bereich des Bodens des Grabens ausdiffundiert.

Der Dotierstoff, also im vorliegenden Beispiel Bor, kann zuvor durch Ionenimplantation in den Bereich des Bodens des Grabens eingebracht werden.

Das erfindungsgemäße Verfahren stellt so eine leichte Modifikation eines VDMOS-Prozesses mit einem selbstjustierenden Kontaktloch für den Graben dar: nachdem der Graben tief geätzt ist, wird auf dem Boden des Grabens Dotierstoff des anderen Leitungstyps, also beispielsweise Bor, implantiert und ausdiffundiert. Danach wird der Graben teilweise mit Isoliermaterial, insbesondere "Flowglas" aufgefüllt, wobei aber der pn-Übergang zwischen der ersten und der zweiten Zone im Graben frei bleibt. Das durch die Ausdiffusion des Dotierstoffes des anderen Leitungstyps geschaffene Gebiet erreicht die zweite Zone des anderen Leitungstyps, so daß insgesamt, wenn für die Ausdiffusion Bor verwendet wird, ein zusammenhängendes p-leitendes Gebiet im Bereich um den Boden des Grabens bis zu der ersten Zone des einen Leitungstyps entsteht. Gegebenenfalls können dabei noch weitere "vergrabene" Gebiete des anderen Leitungstyps, die unterhalb des Gebietes des anderen Leitungstyps liegen, vorgesehen sein. Solche weiteren Gebiete des anderen Leitungstyps können durch epitaktische Abscheidungen einzelner Halbleiterschichten und Implantation geschaffen werden.

Abschließend wird, nachdem die einzelnen Schritte zur Schaffung des Gebietes des anderen Leitungstyps ausgeführt sind, noch eine Metallisierung erstellt.

In vorteilhafter Weise ist im Halbleiterkörper eine obere Epitaxieschicht höher dotiert als darunterliegende Schichten. Das heißt, wenn das Gebiet des anderen Leitungstyps durch Ausdiffusion von Bor p-leitend ist, ist eine obere Epitaxieschicht, in welcher die erste Zone des einen Leitungstyps und die zweite Zone des anderen Leitungstyps liegen, n⁺-leitend. Die darunter vorgesehenen Epitaxieschichten sind dann n-leitend.

Insgesamt entsteht so ein niederohmiges VDMOS-Halbleiterbauelement, bei dem die Leitfähigkeit des Strompfades im n-leitenden Halbleiterkörper etwa verdoppelt ist, womit der Einschaltwiderstand auf die Hälfte reduziert werden kann. Für Anwendungen unterhalb etwa 100 V ist bereits ein weiteres Gebiet des anderen Leitungstyps unterhalb des Gebietes des anderen Leitungstyps ausreichend. Für höhere Spannungen können entsprechend mehr Gebiete des anderen Leitungstyps vorgesehen werden.

Bei dem erfindungsgemäßen VDMOS-Halbleiterbauelement handelt es sich in bevorzugter Weise um einen VDMOS-Feldeffekttransistor. Ebenso kann die Erfindung aber auch in vorteilhafter Weise für IGBT's angewandt werden.

Nachfolgend wird die Erfindung anhand der Zeichnungen näher erläutert. Es zeigen:
- Fig. 1 und 2: Schnitte zur Erläuterung der Herstellung eines erfindungsgemäßen VDMOS-Feldeffekttransistors,
- Fig. 3: einen Schnitt durch einen IGBT gemäß der Erfindung,
- Fig. 4: einen Schnitt durch einen bestehenden Trench-Feldeffekttransistor und
- Fig. 5: einen Schnitt durch einen anderen bestehenden Feldeffekttransistor.

Die Fig. 4 und 5 sind bereits eingangs erläutert worden. Für entsprechende Bauteile werden in den Figuren jeweils die gleichen Bezugszeichen verwendet.

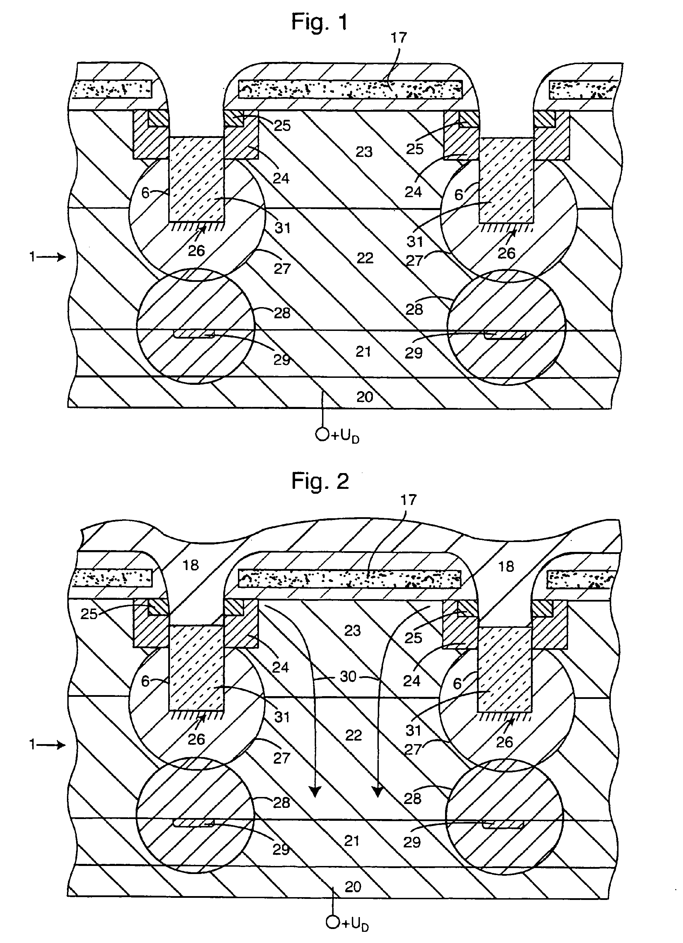

Fig. 1 zeigt einen Halbleiterkörper 1 mit einer n⁺⁺-leitenden Drainzone bzw. einem Substrat 20, einer n-leitenden ersten Epitaxieschicht 21, einer n-leitenden zweiten Epitaxieschicht 22. und einer n⁺-leitenden Epitaxieschicht 23. In die Epitaxieschicht 23 ist eine ringförmige p-leitende Halbleiterzone 24 eingebettet, in welcher sich wiederum eine n⁺-leitende Sourcezone 25 befindet. Der Halbleiterkörper 1 und damit die Zonen bzw. Schichten 20 bis 25 bestehen aus entsprechend dotiertem Silizium.

Durch die Zonen 24 und 25 wird ein Graben 6 eingebracht, der sich etwa bis zu der Epitaxieschicht 22 erstreckt. Durch Ionenimplantation wird in den Boden 26 des Grabens 6 Dotierstoff des anderen Leitungstyps, also beispielsweise Bor, wenn der eine Leitungstyps n-leitend ist, implantiert und ausdiffundiert, so daß ein p-leitendes Gebiet 27 entsteht. Dieses p-leitende Gebiet 27 reicht bis zur Zone 24.

Nach Fertigstellung von Gateelektroden 17 in einer Gateisolierschicht 16 aus Siliziumdioxid wird eine Metallisierung 18 (vgl. Fig. 2) aus beispielsweise Aluminium zur Kontaktierung der Zonen 25, 24 angebracht.

Gegebenenfalls können unterhalb des Gebietes 27 noch weitere Gebiete 28 des anderen Leitungstyps, also im vorliegenden Beispiel p-leitende Gebiete, vorhanden sein. Diese Gebiete werden durch Implantation von Bor in Bereiche 29 der Epitaxieschicht 21 und Ausdiffusion des Bors nach Auftragen der nächsten Epitaxieschicht 22 erstellt.

Damit wird insgesamt ein VDMOS-Feldeffekttransistor mit der in Fig. 2 gezeigten Struktur erhalten, in welcher auch Pfeile 30 angegeben sind, die den Verlauf des Strompfades zwischen Source und Drain veranschaulichen.

Fig. 3 zeigt als weiteres Ausführungsbeispiel der Erfindung einen IGBT, wobei hier der Graben 6 vollständig mit Isolierstoff 31 aus beispielsweise Siliziumdioxid gefüllt ist. Bei dem VDMOS-Feldeffekttransistor der Fig. 1 und 2 reicht dieser Isolierstoff 31 nur bis zu einer solchen Höhe im Graben 6, daß der pn-Übergang zwischen der ersten Zone 25 und der zweiten Zone 24 von Isoliermaterial frei ist.

Fig. 3 zeigt noch einen Drainkontakt 32 der die hier p⁺-leitende Epitaxieschicht 20 kontaktiert, auf der gegebenenfalls eine n⁺-leitende Epitaxieschicht 21 und eine n⁻-leitende Epitaxieschicht 22 vorgesehen sein können.

## Patentansprüche

1. Niederohmiges VDMOS-Halbleiterbauelement mit planarer Gatestruktur, bei dem in einem Halbleiterkörper (1) des einen Leitungstyps, der zwei einander im wesentlichen gegenüberliegende Hauptoberflächen aufweist, im Bereich der einen Hauptoberfläche eine hochdotierte erste Zone (25) des einen Leitungstyps vorgesehen ist, die durch eine zweite Zone (24) des anderen Leitungstyps von dem Halbleiterkörper getrennt ist, und bei dem die erste und die zweite Zone (25, 24) von einem bis zum Halbleiterkörper reichenden Graben (6) durchsetzt sind, der wenigstens bis über einen dem Halbleiterkörper (1) zugewandten Rand der zweiten Zone (24) hinaus mit Isoliermaterial (31) gefüllt ist,
**dadurch gekennzeichnet, dass**
- im Bereich des Bodens (26) des Grabens (6) ein diesen Bereich umgebendes Gebiet (27) des anderen Leitungstyps vorgesehen ist.

2. Niederohmiges VDMOS-Halbleiterbauelement nach Anspruch 1,
**dadurch gekennzeichnet, daß** das Gebiet (27) des anderen Leitungstyps bis zur zweiten Zone (24) reicht und der Graben (6) mit leitendem Material (18) wenigstens bis zu dem der einen Hauptoberfläche zugewandten Rand der zweiten Zone (24) gefüllt ist.

3. Niederohmiges VDMOS-Halbleiterbauelement nach Anspruch 1 oder 2,
**dadurch gekennzeichnet, daß** im Halbleiterkörper (1) unterhalb des Gebietes (27) des anderen Leitungstyps wenigstens ein an dieses angrenzendes weiteres Gebiet (28) des anderen Leitungstyps vorgesehen ist.

4. Niederohmiges VDMOS-Halbleiterbauelement nach Anspruch 1,
**dadurch gekennzeichnet, daß** der Graben (6) mit Isoliermaterial (31) gefüllt ist.

5. Niederohmiges VDMOS-Halbleiterbauelement nach einem der Ansprüche 1 bis 4,
**dadurch gekennzeichnet, daß** das Isoliermaterial Glas ist.

6. Niederohmiges VDMOS-Halbleiterbauelement nach einem der Ansprüche 1 bis 5,
**dadurch gekennzeichnet, daß** eine an die eine Hauptoberfläche angrenzende Epitaxieschicht (23) des Halbleiterkörpers höher dotiert ist als darunterliegende Epitaxieschichten (21, 22).

7. Niederohmiges VDMOS-Halbleiterbauelement nach einem der Ansprüche 1 bis 6,
**dadurch gekennzeichnet, daß** das Gebiet (27) des anderen Leitungstyps mit Bor dotiert ist.

8. Verfahren zum Herstellen eines niederohmigen VDMOS-Halbleiterbauelements nach einem der Ansprüche 1 bis 7,
**dadurch gekennzeichnet, daß** das Gebiet des anderen Leitungstyps (27) durch Ausdiffusion eines Dotierstoffes des anderen Leitungstyps aus dem Bereich des Bodens (26) des Grabens (6) hergestellt wird.

9. Verfahren nach Anspruch 8,
**dadurch gekennzeichnet, daß** Bor aus dem Bereich des Bodens (26) des Grabens (6) ausdiffundiert wird.

10. Verfahren nach Anspruch 8 oder 9,
**dadurch gekennzeichnet, daß** der Dotierstoff des anderen Leitungstyps durch Ionenimplantation in den Bereich des Bodens (26) des Grabens (6) eingebracht wird.

## Claims

1. Low-resistance VDMOS semiconductor component with a planar gate structure in which, in a semiconductor body (1) of a first conduction type having two main surfaces essentially lying opposite one another, a highly-doped first zone (25) of the first conduction type is provided in the region of a first main surface, said first zone being separated from the semiconductor body by a second zone (24) of a second conduction type, and in which a trench (6) reaching as far as the semiconductor body penetrates through the first and second zones (25, 24), said trench being filled with insulating material (31) at least to beyond an edge of the second zone (24) that faces the semiconductor body (1),
**characterized in that**
- a region (27) of the second conduction type surrounding the region of the bottom (26) of the trench (6), is provided in said region of the bottom of the trench.

2. Low-resistance VDMOS semiconductor component according to Claim 1
**characterized in that**
the region (27) of the second conduction type reaches as far as the second zone (24) and the trench (6) is filled with conductive material (18) at least as far as the edge of the second zone (24) that faces said first main surface.

3. Low-resistance VDMOS semiconductor component according to Claim 1 or 2,
**characterized in that**
at least one further region (28) of the second conduction type adjoining the region (27) of the second conduction type is provided in the semiconductor body (1) below said region (27) of the second conduction type.

4. Low-resistance VDMOS semiconductor component according to Claim 1
**characterized in that**
the trench (6) is filled with insulating material (31).

5. Low-resistance VDMOS semiconductor component according to one of Claims 1 to 4,
**characterized in that**
the insulating material is glass.

6. Low-resistance VDMOS semiconductor component according to one of Claims 1 to 5,
**characterized in that**
an epitaxial layer (23) of the semiconductor body that adjoins said first main surface is doped more highly than underlying epitaxial layers (21, 22).

7. Low-resistance VDMOS semiconductor component according to one of Claims 1 to 6,
**characterized in that**
the region (27) of the second conduction type is doped with boron.

8. Method for producing a low-resistance VDMOS semiconductor component according to one of Claims 1 to 7,
**characterized in that**
the region of the second conduction type (27) is produced by outdiffusion of a dopant of the second conduction type from the region of the bottom (26) of the trench (6).

9. Method according to Claim 8,
**characterized in that**
boron is outdiffused from the region of the bottom (26) of the trench (6).

10. Method according to Claim 8 or 9,
**characterized in that**
the dopant of the second conduction type is introduced by ion implantation into the region of the bottom (26) of the trench (6).

## Revendications

1. Composant à semi-conducteurs VDMOS à petite valeur ohmique ayant une structure de grille plane, dans lequel il est prévu, dans un corps (1) semi-conducteur d'un type de conductivité qui a deux surfaces principales sensiblement opposées l'une à l'autre, dans la zone de l'une des surfaces principales, une première zone (25) très dopée du un type de conductivité qui est séparée du corps semi-conducteur par une deuxième zone (24) de l'autre type de conductivité, et dans lequel la première et la deuxième zones (25, 24) sont traversées par un sillon (6) allant jusqu'au corps semi-conducteur, qui est empli de matériau (31) isolant au moins jusqu'au-delà d'un bord de la deuxième zone (24), qui est tourné vers le corps (1) semi-conducteur,
**caractérisé en ce que**
- il est prévu dans la partie du fond (26) du sillon (6) une région (27) de l'autre type de conductivité qui entoure cette partie.

2. Composant à semi-conducteur VDMOS à basse valeur ohmique suivant la revendication 1,
**caractérisé en ce que** la zone (27) de l'autre type de conductivité va jusqu'à la deuxième zone (24) et le sillon (6) est empli de matériau (18) conducteur au moins jusqu'au bord de la deuxième zone (24), qui est tourné vers la une surface principale.

3. Composant à semi-conducteur VDMOS à basse valeur ohmique suivant la revendication 1 ou 2,
**caractérisé en ce qu'**il est prévu dans le corps (1) semi-conducteur en dessous de la zone (27) de l'autre type de conductivité au moins une autre zone (28) de l'autre type conductivité qui en est voisine.

4. Composant à semi-conducteur VDMOS à basse valeur ohmique suivant la revendication 1,
**caractérisé en ce que** le sillon (6) est empli de matériau (31) isolant.

5. Composant à semi-conducteur VDMOS à basse valeur ohmique suivant l'une des revendications 1 à 4,
**caractérisé en ce que** le matériau isolant est du verre.

6. Composant à semi-conducteur VDMOS à basse valeur ohmique suivant l'une des revendications 1 à 5,
**caractérisé en ce qu'**une couche (23) épitaxiale du corps semi-conducteur voisine de la une surface principale est plus dopée que des couches (21, 22) épitaxiales sous-jacentes.

7. Composant à semi-conducteur VDMOS à basse valeur ohmique suivant l'une des revendications 1 à 6,
**caractérisé en ce que** la zone (27) de l'autre type de conductivité est dopée par du bore.

8. Procédé de production d'un composant à semi-conducteurs VDMOS à basse valeur ohmique suivant l'une des revendications 1 à 7,
**caractérisé en ce que** l'on produit la zone de l'autre type (27) de conductivité par diffusion d'une substance de dopage de l'autre type de conductivité à partir de la zone du fond (26) du sillon (6).

9. Procédé suivant la revendication 8,
**caractérisé en ce que** du bore diffuse à partir de la partie du fond (26) du sillon (6).

10. Procédé suivant la revendication 8 ou 9,
**caractérisé en ce que** la substance de dopage de l'autre type de conductivité est introduite par implantation d'ions dans la partie du fond (26) du sillon (6).
